# EUROPÄISCHE PATENTSCHRIFT

(11) **EP 0 757 412 B1**
(45) Veröffentlichungstag und Bekanntmachung des Hinweises auf die Patenterteilung: **13.12.2000**
(21) Anmeldenummer: 96108707.9
(22) Anmeldetag: 31.05.1996
(51) Int. Cl.: H03H 7/46

(54) **Antennensteckdose**
Antenna plug socket
Prise de contact d'antenne

(30) Priorität: 02.08.1995 DE 19528370
(43) Veröffentlichungstag der Anmeldung: 05.02.1997
(73) Patentinhaber: Richard Hirschmann GmbH & Co., 72654 Neckartenzlingen (DE)
(72) Erfinder: Wendel, Wolfgang, 73257 Köngen (DE); Epple, Ralf, 73669 Lichtenwald (DE); Blind, Manfred, 70597 Stuttgart (DE)
(74) Vertreter: Stadler, Heinz, Dipl.-Ing.

(56) Entgegenhaltungen:
- DE-A- 3 537 312
- DE-A- 4 327 117
- DE-C- 4 301 648

## Beschreibung

Die Erfindung betrifft eine Antennensteckdose gemäß dem Oberbegriff des Anspruches 1. Eine derartige sogenannte Vierlochdose ist aus DE 4301648 und beispielsweise durch die Antennensteckdose mit der Typenbezeichnung "SAT400EAS DC" der Firma Ankaro bekannt, von der ein Prinzipschaltbild in Figur 4 dargestellt ist.
Solche Antennensteckdosen sind für den Einsatz in sogenannten Zweikabel-Verteilnetzen vorgesehen, bei denen auf jedem Kabel Satellitenprogramme im ersten Satelliten-Zwischenfrequenzbereich zusammen mit den terrestrischen RF-(UKW) und TV-Signalen übertragen werden und jeder Eingang an eines der beiden Kabel angeschlossen ist. Die terrestrischen Signale werden von einem ersten Eingang auf zwei Teilnehmeranschlüsse ausgekoppelt, die Satellitensignale von beiden Eingängen aus über je einen Hochpaß für den ersten Satelliten-Zwischenfrequenzbereich auf je einen weiteren Teilnehmeranschluß. Der erste Eingang ist folglich breitbandig, der zweite kann auch nur für den ersten Satelliten-Zwischen-frequenzbereich ausgelegt sein.
An den beiden Teilnehmeranschlüssen für Satellitenempfang können entweder horizontal oder vertikal polarisierte Satellitensignale eines Satelliten oder jeweils eine der beiden Polarisationen zweier Satelliten oder schließlich - durch Umschaltung - jeweils wahlweise die horizontal oder vertikal polarisierten Signale eines von zwei Satelliten empfangen werden. Das Umschalten kann in bekannter Weise entweder spannungsgesteuert (14/18 V) oder frequenzgesteuert (0/22 kHz) erfolgen, wozu jedem Hochpaß eine Drossel parallel geschaltet ist.

Diese bekannten Antennensteckdosen sind zwar grundsätzlich auch in BK-Netzen (Breitband-Kabelnetzen) verwendbar, sofern das zur Übertragung des gesamten Betriebsfrequenzbereichs eingesetzte einzige Kabel am ersten Eingang angeschlossen wird. Dabei können jedoch nur die beiden Teilnehmeranschlüsse für den terrestrischen RF- bzw. TV-Empfang benutzt werden, da der Übertragungsfrequenzbereich solcher Breitbandnetze derzeit nur bis 600 MHz reicht und auch zukünftig allenfalls bis 860 MHz erweitert werden wird, so daß durch die beiden Hochpässe mit einer Grenzfrequenz von etwa 950 MHz keine Signale mehr zu den Teilnehmeranschlüssen für Satellitenempfang gelangen können.
Für die beiden geschilderten Anwendungsfälle müssen somit unterschiedliche Antennensteckdosen bereitgestellt werden, was eine spürbare Verteuerung der Fertigung und Lagerhaltung zur Folge hat. Die eingeschränkte Einsatzmöglichkeit der bekannten Antennensteckdosen bedingt darüber hinaus einen erhöhten Aufwand beim Installateur sowie eine weitere Erhöhung des Herstellungspreises auf Grund der geringeren Stückzahlen jeder Dosenart.
Der Erfindung liegt daher die Aufgabe zugrunde, eine Antennensteckdose der eingangs genannten Art auf möglichst einfache und kostengünstige Weise derart weiterzubilden, daß alle vier Teilnehmeranschlüsse sowohl beim Einsatz in einem Zweikabel-Verteilnetz als auch in einer BK-Anlage zur Signalübertragung benutzbar sind.
Diese Aufgabe ist durch die kennzeichnenden Merkmale des Anspruches 1 gelöst. Dabei ist der im Stand der Technik vorgesehene Hochpaß für den ersten Satelliten-Zwischenfrequenzbereich im Signalzweig vom ersten Eingang zum ersten Teilnehmeranschluß entfallen, die erforderliche Entkopplung der Teilnehmeranschlüsse für terrestrischen RF- und TV-Empfang vom ersten Teilnehmeranschluß für Satellitenempfang ist durch die Bandsperre, den Bandpaß und den Zweifachverteiler gewährleistet.
Ohne jeglichen Mehraufwand im Vergleich zu dem beschriebenen Stand der Technik (vier Filter beim Stand der Technik, drei Filter und ein Verteiler beim Erfindungsgegenstand) ist damit erreicht, daß die erfindungsgemäße Antennendsteckdose beim Einsatz in einem BK-Netz auch am ersten und zweiten Teilnehmeranschluß, welche bei Verwendung der Antennensteckdose in einem Zweikabel-Verteilnetz für den Satellitenempfang vorgesehen sind, und somit an allen vier Teilnehmeranschlüssen eine Signalübertragung möglich ist. Beispielsweise kann der Tiefpaß eine Grenzfrequenz von ca. 35 MHz aufweisen. Damit kann über dem zweiten Teilnehmeranschluß ein Rückkanal-Betrieb im Frequenzbereich von 4 bis 30 MHz erfolgen, wie er heute schon von erheblicher Bedeutung ist. Im Hinblick auf die zukünftige Multimedia-Technik für die gegenseitige Kommunikation von Teilnehmern über die Kopfstation der Anlage mit den verschiedensten Institutionen ist darüber hinaus auch die Vorwärtskommunikation (vom Eingang zum Teilnehmer) von wesentlichem Interesse; für diesen Fall liegt die Grenzfrequenz des Tiefpasses zum Beispiel bei 84 MHz (eine Übertragung des Fernsehbereiches I kann allerdings in diesem Fall nicht erfolgen). Am ersten Teilnehmeranschluß könnte zum Beispiel ein DSR-Empfänger, ein zweiter UKW- oder TV-Empfänger (für einen anderen Raum) oder ein Videogerät angeschlossen werden (wobei das lästige Durchleifen von der Antenne über das Videogerät zum TV-Empfänger entfallen würde). Auch am dritten Teilnehmeranschluss für den terrestrischen TV-Empfang könnte im übrigen statt dessen eine Rückkanal-Übertragung vorgesehen werden.
Somit ist eine Doppelnutzung der Antennensteckdose sowohl für Zweikabel-Verteilnetze mit Übertragung von terrestrischen und Satellitensignalen im ersten Satellitenzwischenfrequenzbereich als auch für BK-Netze erreicht, bei der stets an allen vier Teilnehmeranschlüssen Endgeräte betrieben werden können. Dieser universelle Einsatz reduziert den Preis der Antennensteckdose und vereinfacht die Lagerhaltung und Anwendung in erheblichem Maße.

In den Unteransprüchen sind vorteilhafte Ausführungen bzw. Ausgestaltungen der Antennensteckdose gemäß dem Hauptanspruch angegeben.
Durch die in den Ansprüchen 2 und 3 vorgesehenen Hochpässe sind Störungen durch unerwünschte bzw. unbeabsichtigte elektrische Bedingungen am ersten Teilnehmeranschluß bzw. am zweiten Eingang, wie zum Beispiel Kurzschluß, Leerlauf oder ein defektes Gerät, wirksam vermieden.
Wird die Grenzfrequenz der beiden Hochpässe gleich groß gewählt (Anspruch 4) so ist darüber hinaus eine maximale Übertragungsbandbreite des Signalwegs vom ersten Eingang zum ersten Teilnehmeranschluß erzielt.

Die bei einer Ausgestaltung der Antennensteckdose nach Anspruch 5 und 6 vorgesehenen Drosseln ermöglichen in an sich bekannter Weise die Übertragung einer Schaltspannung oder Schaltfrequenz trotz der Hochpässe vom ersten Teilnehmeranschluß auf den ersten Eingang und vom zweiten Teilnehmeranschluß auf den zweiten Eingang zum Umschalten der Polarisation der von der Empfangseinrichtung weitergeführten Satellitensignale. Dadurch kann an den beiden relevanten Teilnehmeranschlüssen das vollständige Programmangebot (horizontale und vertikale Polarisation) zweier Satelliten empfangen werden.

Bei solchen Anlagen mit Umschaltmöglichkeit für die Polarisation ist durch einen weiteren Hochpaß gemäß Anspruch 7 ebenso einfach wie wirksam vermieden, daß beim Umschalten durch den einen Teilnehmer zugleich auch die Polarisation des vom anderen Teilnehmer empfangenen Satellitensignals umgeschaltet wird.

Durch ein Widerstandsdämpfungsglied zwischen Tiefpaß und dem zweiten Teilnehmeranschluß gemäß Anspruch 8 wird zwar die Durchgangsdämpfung zwischen dem ersten Eingang und dem zweiten Teilnehmeranschluß erhöht (was bei ausreichend vorhandenem Pegel nicht stört), dafür aber der Übertragungsfrequenzbereich auf dem Signalweg vom ersten Eingang zum zweiten Teilnehmeranschluß ohne Änderung der Grenzfrequenz des Tiefpasses auf ca. 85 MHz erweitert, wodurch auf diesem Signalweg auch eine Vorwärtskommunikation möglich ist ohne die Übertragungsgüte auf dem Signalweg vom ersten Eingang zum ersten Teilnehmeranschluß zu beeinträchtigen; das bedeutet auch, daß das TV Band I übertragen werden kann.

Durch eine Schaltungsausführung gemäß Anspruch 9 ist sicher vermieden, daß einer der Teilnehmeranschlüsse wegen Belastung durch einen direkt angeschlossenen Hochpaß und / oder ggf. eines Dämpfungsgliedes in seinen elektrischen Übertragungskennwerten erheblich schlechter wird, was ansonsten zum Beispiel bei einem Kurzschluß oder Leerlauf am zweiten Eingang und/oder am ersten oder zweiten Teilnehmeranschluß im ersten Satelliten-Zwischen-frequenzbereich die Durchgangsdämpfung von 1 auf 4 dB anheben und die Rückflußdämpfung von 12 auf 3 dB senken würde.

Bei ausreichender elektrischer Wirksamkeit ist durch eine Ausführung der Teiltiefpässe und des dritten Hochpasses ein minimaler Bauteileaufwand und eine weitere Kostenminimierung erreicht.

Durch eine Ausgestaltung der erfindungsgemäßen Antennensteckdose nach Anspruch 11 ist sichergestellt daß den Teilnehmern an den beiden ersten Teilnehmeranschlüssen ohne jeglichen zusätzlichen Schaltungsmehraufwand gleiche Pegel zur Verfügung gestellt werden.

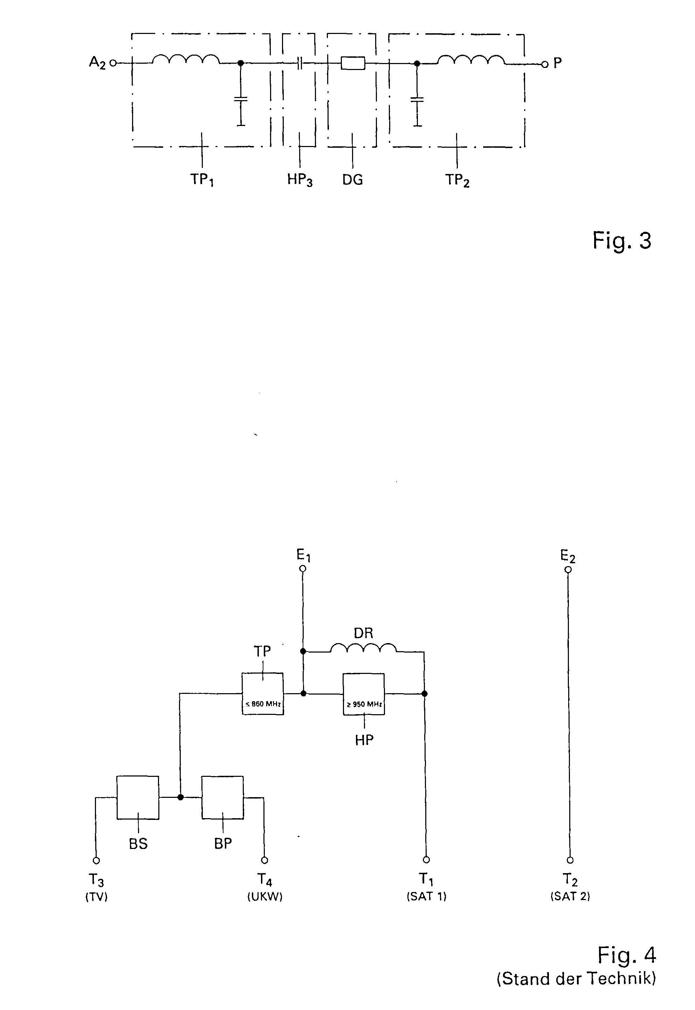

Die Erfindung ist nachfolgend noch an Hand eines Ausführungsbeispieles in den Figuren 1 bis 3 näher erläutert. Es zeigen
- Figur 1-: ein Prinzipschaltbild der erfindungsgemäßen Antennensteckdose nach Anspruch 1,
- Figur 2 -: das Blockschaltbild einer realisierten Ausführung und
- Figur 3 -: ein Schaltbild des Querzweiges gemäß Figur 2

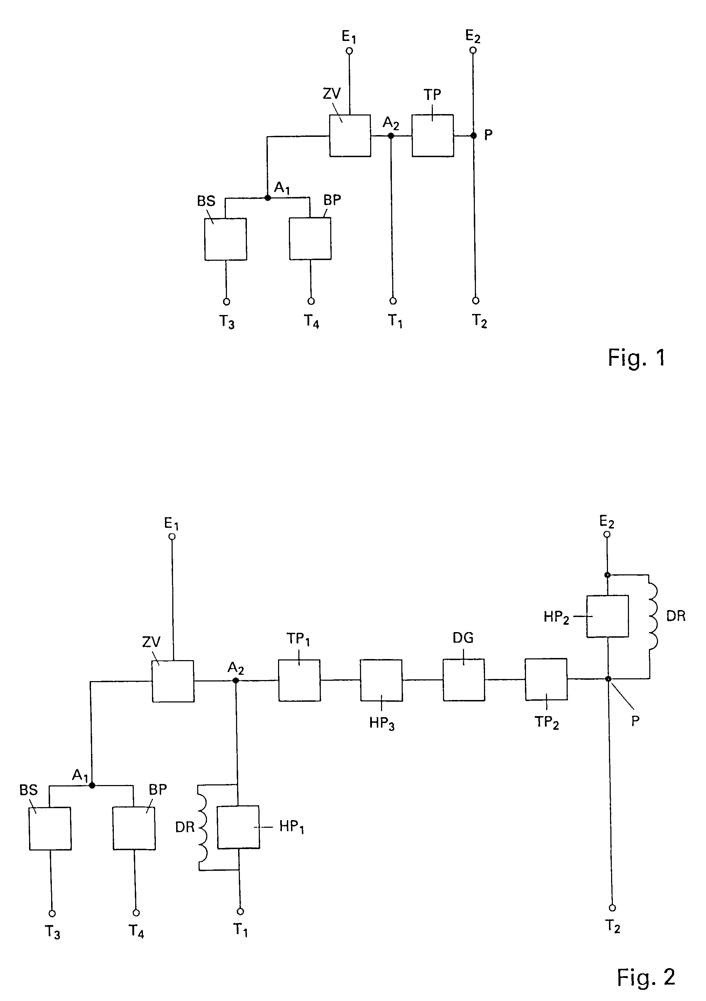

Die Schaltung nach Figur 1 weist zwei breitbandige (4 MHz...2,5 GHz) Eingänge E1 und E2 sowie vier Teilnehmeranschlüsse T1...T4 zum Anschluß von Endgeräten auf. Die am ersten Eingang anliegenden HF-Signale gelangen zu einem breitbandigen Zweifachverteiler ZV und von dessen erstem Ausgang A1 auf eine Bandsperre BS und einen Bandpaß BP für den UKW-Bereich, deren Ausgänge zugleich die Teilnehmeranschlüsse T3 und T4 bilden. Am vierten Teilnehmeranschluß T4 kann somit ein UKW-Empfänger und am dritten Teilnehmeranschluß T3 ein TV-Empfänger angeschlossen werden.
Der zweite Ausgang A2 des Zweifachverteilers ZV ist zum einen direkt mit dem Teilnehmeranschluß T1 verbunden und zum anderen über einen Tiefpaß TP mit einer Grenzfrequenz von 30 MHz über einen Schaltungspunkt P, der mit dem zweiten Eingang E2 direkt in Verbindung steht, mit dem zweiten Teilnehmeranschluß T2. Die beiden ersten Teilnehmeranschlüsse T1, T2 sind für Satellitenempfang vorgesehen, und zwar entweder für den Empfang der horizontalen und vertikalen Polarisation der Signale eines einzigen Satelliten oder - durch Umschaltung mittels eines von den Empfängern übertragenen Schaltsignals jeweils wahlweise der Programme mit horizontaler oder vertikaler Polarisation zweier Satelliten.

Bei Einsatz der Antennensteckdose in einem Zweikabel-Verteilnetz einer Empfangsanlage, bei der auf jedem Kabel sowohl Satellitenprogramme im ersten Satelliten-Zwischenfrequenzbereich als auch die von einer terrestrischen Antennenanlage der gemeinsamen Kopfstation gelieferten und über eine Weiche hinzugefügten terrestrischen RF- und TV-Programme übertragen werden, wäre die angeführte Belegung aller vier Teilnehmeranschlüsse auch ohne den Tiefpaß möglich. Bei einem Einsatz in einem BK-Netz jedoch, bei dem die Übertragung aller Signale durch eine entsprechende Aufbereitungseinheit im Frequenzbereich bis derzeit maximal 600 MHz über ein Kabel erfolgt, an das der erste Eingang E1 angeschlossen ist, kann durch den breitbandigen Zweifachverteiler der erste Teilnehmeranschluß auch in diesem Bereich genutzt werden (während beim Stand der Technik ein Hochpaß mit einer Grenzfrequenz von etwa 950 MHz diesen Bereich sperrt) und zusätzlich durch den Tiefpaß auch der zweite Teilnehmeranschluß T2, nämlich zum Beispiel für einen Rückkanal-Betrieb, bei dem der Teilnehmer über die Kopfstation etwa Aufträge an seine Bank übermittelt. Am ersten Teilnehmeranschluß T1 kann beispielsweise ein zweiter Rundfunk- oder Fernsehempfänger oder aber auch ein Videogerät installiert werden.
Die erfindungsgemäße Antennensteckdose ist also sowohl in Individualanlagen als auch in öffentlichen Breitbandnetzen in einer einzigen Ausführung einsetzbar, wodurch geringe Herstellungskosten, eine günstige Lagerhaltung sowie eine einfache Handhabung durch den Installateur gewährleistet sind.

Zur Verbesserung der Nutzungseigenschaften dieser Antennensteckdose sind bei der praktischen Ausführung der Schaltung nach Figur 2 weitere Bauteile vorgesehen:
Zwischen dem zweiten Ausgang A2 des Zweifachverteilers ZV und dem ersten Teilnehmeranschluß T1 sowie zwischen dem zweiten Eingang E2 und dem Schaltungspunkt P ist jeweils ein Hochpaß HP1, HP2 mit einer Grenzfrequenz von 40 MHz eingeschaltet, wobei beide Hochpässe HP1, HP2 durch jeweils eine Drossel DR überbrückt sind. Des weiteren ist der Tiefpaß in zwei aus je einem Halbglied aufgebaute Teiltiefpässe TP1, TP2 aufgeteilt, zwischen denen ein dritter Hochpaß HP3 mit einer Grenzfrequenz von 3,8 MHz sowie ein Dämpfungsglied DG eingeschaltet sind.

Die beiden Hochpässe HP1 und HP2 bewirken auf einfache Weise eine sichere Vermeidung von Störungen durch Fehlabschlüsse des ersten Teilnehmeranschlusses T1 und des zweiten Einganges E2. Außerdem ist eine maximale Übertragungsbandbreite für den Signalweg vom ersten Eingang E1 zum ersten Teilnehmeranschluß T1 erreicht.

Die Drosseln sind dazu vorgesehen, Schaltsignale (entweder 14/18 Volt Gleichspannung oder 1 Volt Wechselspannung mit 0/22 kHz) zur Umschaltung der Polarisationsrichtungen von den an den ersten beiden Teilnehmeranschlüssen T1, T2 angeschlossenen Satellitenempfängern über die zugeordneten Eingänge E1, E2 auf die Satellitenantenne übertragen zu können.
Der im Querzweig vorgesehene dritte Hochpaß HP3 verhindert wirksam, daß beim Polarisationsumschalten eines Teilnehmers zugleich - und in aller Regel unerwünscht - die Polarisation für den Satellitenempfänger am anderen Teilnehmeranschluß ebenfalls umgeschaltet wird, ohne dabei die Möglichkeit einer Rückkanalübertragung bei einem Einsatz in einem BK-Netz zu beeinträchtigen.
Dieser dritte Hochpaß HP3 würde jedoch, wenn er direkt an den zweiten Ausgang A2 des Zweifachverteilers ZV oder den Schaltungspunkt P angeschlossen wäre, den ersten oder zweiten Teilnehmeranschluß T1 oder T2 hinsichtlich seiner Übertragungskennwerte im ersten Satelliten-Zwischenfreqeuenzbereich ganz wesentlich belasten. So würde die Durchgangsdämpfung bis auf 4 dB ansteigen und die Rückflußdämpfung bis auf etwa 3 dB sinken, was zu erheblichen Empfangsbeeinträchtigungen führen kann, insbesondere wenn eine Vielzahl von Teilnehmern im Netz angeschlossen ist. Dieser Nachteil wird in der vorliegenden Schaltung dadurch vermieden, daß der Tiefpaß in zwei Halbglieder TP1, TP2 aufgeteilt ist, die direkt am zweiten Ausgang A2 des Zweifachverteilers ZV bzw. am Schaltungspunkt P angeschlossen sind und der dritte Hochpaß HP 3 dazwischen eingeschaltet ist.

Aus dem gleichen Grund ist ein Widerstands-Dämpfungsglied zwischen die Teiltiefpässe TP1, TP2 eingeschaltet, welches den Übertragungsfrequenzbereich des Signalweges vom ersten Eingang E1 zum zweiten Teilnehmerausgang T2 auf ca. 85 MHz erweitert und dadurch auch eine Vorwärtskommunikation von der Kopfstation zum Teilnehmer ermöglicht, ohne die Übertragung auf dem Signalweg vom ersten Eingang E1 zum ersten Teilnehmeranschluß T1 zu beeinträchtigen.

Der Zweifachverteiler ZV ist derart unsymmetrisch (d.h. mit unterschiedlicher Verteildämpfung der beiden Ausgänge A1, A2) ausgelegt, daß die Anschlußdämpfung an den beiden ersten Teilnehmeranschlüssen T1, T2 bei Satellitenempfang (Zweikabel-Verteilnetz) etwa gleich groß ist, sodaß beide angeschlossene Satellitenempfänger etwa den gleichen Pegel erhalten.

Insgesamt ist dadurch mit einer geringfügigen Mehranzahl von Bauteilen gegenüber dem Stand der Technik eine hinsichtlich der Übertragungseigenschaften hochwertige, zum Einsatz in beiden für die Praxis wichtigen Netztypen geeignete Universal-Antennensteckdose geschaffen, die preislich günstig ist und eine im Vergleich zum Stand der Technik unveränderte äußere Baugröße aufweist, die den Einsatz in herkömmlichen 55 mm-UP-Schalterdosen ermöglicht.
Selbstverständlich ist die erfindungsgemäße Antennensteckdose sowohl als Durchgangsdose wie auch als Enddose ausführbar.

## Patentansprüche

1. Antennensteckdose mit zwei Eingängen (E1, E2) und vier Teil ehmeranschlüssen (T1...T4) für RF-,TV- und ggf. Satellitenempfang in einem ersten Satelliten-Zwischenfrequenzbereich, wobei von jedem Eingang (E1 bzw. E2) jeweils ein Satellitensignal auf einen ersten bzw. zweiten Teilnehmeranschluß (T1 bzw. T2) übertragbar ist und von einem ersten Eingang (E1) auf die beiden übrigen Teilnehmeranschlüsse (T3, T4) der RF- und der TV-Bereich selektiv ausgekoppelt werden,
bei der
dem ersten Eingang (E1) ein breitbandiger Zweifachverteiler (ZV) nachgeschaltet ist, dessen erster Ausgang (A1) über Selektionsmittel (BS, BP) zur Trennung der terrestrischen RF- und TV-Signale mit deren Teilnehmeranschlüssen (T3, T4) verbunden ist und dessen zweiter Ausgang (A2) zugleich mit dem zugehörigen ersten Teilnehmeranschluß (T1) und über einen Tiefpaß (TP) mit dem am zweiten Eingang (E2) angeschlossenen zweiten Teilnehmeranschluß (T2) verbunden ist, wobei die Grenzfrequenz des Tiefpasses (TP) oberhalb der höchsten, auf dem Signalweg vom ersten Eingang (E1) zum zweiten Teilnehmeranschluß (T2) bei leerlaufendem zweiten Eingang (E2) übertragenen Signalfrequenz und unterhalb der niedrigsten am ersten Teilnehmeranschluß (T1) übertragenen Signalfrequenz liegt.

2. Antennensteckdose nach Anspruch 1, dadurch gekennzeichnet, daß zwischen dem zweiten Ausgang (A2) des Zweifachverteilers (ZV) und dem ersten Teilnehmeranschluß (T1) ein erster Hochpaß (HP1) eingeschaltet ist, dessen Grenzfrequenz größer als die Grenzfrequenz des Tiefpasses (TP) ist.

3. Antennensteckdose nach Anspruch 1 oder 2, dadurch gekennzeichnet, daß zwischen dem zweiten Eingang (E2) und dem Verbindungspunkt (P) von Tiefpaß (TP) und zweitem Teilnehmeranschluß (T2) ein zweiter Hochpaß (HP2) vorgesehen ist, dessen Grenzfrequenz zwischen derjenigen des Tießpasses (TP) und der niedrigsten Frequenz des auf dem Signalweg vom zweiten Eingang (E2) zum zweiten Teilnehmeranschluß (T2) übertragenen Frequenzbereiches liegt.

4. Antennensteckdose nach Anspruch 2 und 3, dadurch gekennzeichnet, daß die Grenzfrequenz der beiden Hochpässe (HP1, HP2) gleich groß ist.

5. Antennensteckdose nach Anspruch 2, dadurch gekennzeichnet, daß dem ersten Hochpaß (HP1) eine Drossel (DR) parallel geschaltet ist.

6. Antennensteckdose nach Anspruch 3, dadurch gekennzeichnet, daß dem zweiten Hochpaß (HP2) eine Drossel (DR) parallel geschaltet ist.

7. Antennensteckdose nach einem der Ansprüche 1 bis 6, dadurch gekennzeichnet, daß in Serie zu dem Tiefpaß (TP) ein dritter Hochpaß (HP3) vorgesehen ist, dessen Grenzfrequenz der niedrigsten Frequenz des auf dem Signalweg zwischen dem ersten Eingang (E1) und dem zweiten Teilnehmeranschluß (T2) übertragenen Frequenzbereiches entspricht.

8. Antennensteckdose nach einem der Ansprüche 1 bis 7, dadurch gekennzeichnet, daß in Serie zu dem Tiefpaß (TP) ein Dämpfungsglied (DG) eingeschaltet ist.

9. Antennensteckdose nach Anspruch 7 oder 8, dadurch gekennzeichnet, daß der Tiefpaß aus zwei Teiltiefpässen (TP1, TP2) besteht, zwischen denen der dritte Hochpaß (HP3) und / oder das Dämpfungsglied (DG) eingeschaltet ist bzw. sind.

10. Antennensteckdose nach Anspruch 9, dadurch gekennzeichnet, daß die beiden Teiltiefpässe (TP1, TP2) und der dritte Hochpaß (HP3) durch zwei Tiefpaß-Halbglieder mit dazwischengeschaltetem Längskondensator gebildet sind.

11. Antennensteckdose nach einem der Ansprüche 1 bis 10, dadurch gekennzeichnet, daß die Verteildämpfung an den beiden Ausgängen (A1, A2) des Zweifachverteilers (ZV) derart unterschiedlich gewählt ist, daß die Anschlußdämpfung an den beiden ersten Teilnehmeranschlüssen (T1, T2) bei Satellitenempfang über beide Eingänge (E1, E2) etwa gleich groß ist.

## Claims

1. Antenna plug socket having two inputs (E1, E2) and four subscriber connections (T1 ... T4) for RF, TV and, if appropriate, satellite reception in a first satellite intermediate-frequency range, in which case a respective satellite signal can be transmitted from each input (E1 and E2) to a first and second subscriber connection (T1 and T2), respectively, and the RF and TV ranges are coupled out selectively from a first input (E1) to the two remaining subscriber connections (T3, T4),
in which there is connected downstream of the first input (E1) a broadband dual distributor (ZV), whose first output (A1) is connected via selection means (BS, BP) for separating the terrestrial RF and TV signals to subscriber connections (T3, T4) thereof and whose second output (A2) is simultaneously connected to the associated first subscriber connection (T1) and, via a low-pass filter (TP), to the second subscriber connection (T2) connected to the second input (E2), the limiting frequency of the low-pass filter (TP) lying above the highest signal frequency that is transmitted on the signal path from the first input (E1) to the second subscriber connection (T2) with an open-circuited second input (E2) and lying below the lowest signal frequency that is transmitted at the first subscriber connection (T1).

2. Antenna plug socket according to Claim 1, characterized in that a first high-pass filter (HP1), whose limiting frequency is greater than the limiting frequency of the low-pass filter (TP), is connected in between the second output (A2) of the dual distributor (ZV) and the first subscriber connection (T1).

3. Antenna plug socket according to Claim 1 or 2, characterized in that a second high-pass filter (HP2), whose limiting frequency lies between that of the low-pass filter (TP) and the lowest frequency of the frequency range that is transmitted on the signal path from the second input (E2) to the second subscriber connection (T2), is provided between the second input (E2) and the junction point (P) between low-pass filter (TP) and second subscriber connection (T2).

4. Antenna plug socket according to Claims 2 and 3, characterized in that the limiting frequency of the two high-pass filters (HP1, HP2) has the same magnitude.

5. Antenna plug socket according to Claim 2, characterized in that an inductor (DR) is connected in parallel with the first high-pass filter (HP1).

6. Antenna plug socket according to Claim 3, characterized in that an inductor (DR) is connected in parallel to the second high-pass filter (HP2).

7. Antenna plug socket according to one of Claims 1 to 6, characterized in that a third high-pass filter (HP3), whose limiting frequency corresponds to the lowest frequency of the frequency range that is transmitted on the signal path between the first input (E1) and the second subscriber connection (T2), is provided in series with the low-pass filter (TP).

8. Antenna plug socket according to one of Claims 1 to 7, characterized in that an attenuation element (DG) is connected in series with the low-pass filter (TP).

9. Antenna plug socket according to Claim 7 or 8, characterized in that the low-pass filter comprises two low-pass filter elements (TP1, TP2), between which the third high-pass filter (HP3) and/or the attenuation element (DG) are/is connected.

10. Antenna plug socket according to Claim 9, characterized in that the two low-pass filter elements (TP1, TP2) and the third high-pass filter (HP3) are formed by two low-pass filter half-elements with an interposed series capacitor.

11. Antenna plug socket according to one of Claims 1 to 10, characterized in that the distribution attenuation at the two outputs (A1, A2) of the dual distributor (ZV) is chosen to differ such that the connection attenuation at the two first subscriber connections (T1, T2) has approximately the same magnitude in the case of satellite reception via both inputs (E1, E2).

## Revendications

1. Prise d'antenne avec deux entrées (E1, E2) et quatre raccordements d'abonné (T1...T4) pour réception radio, télévision et éventuellement par satellite dans une première gamme de fréquences intermédiaires de satellite, un signal de satellite pouvant être transmis de chaque entrée (E1 ou E2) à un premier ou un deuxième raccordement d'abonné (T1 ou T2), et la gamme radio ainsi que la gamme télévision étant désaccouplées de manière sélective d'une première entrée (E1) aux deux autres raccordements d'abonné (T3, T4), dans laquelle derrière la première entrée (E1) est monté un distributeur double (ZV) à large bande, dont la première sortie (A1) est reliée, par des moyens de sélection (BS, BP), pour la séparation des signaux terrestres radio et télévision, à ses raccordements d'abonné (T3, T4) et dont la deuxième sortie (A2) est reliée en même temps au premier raccordement d'abonné (T1) correspondant et, par un passe-bas (TP), au deuxième raccordement d'abonné (T2) connecté à la deuxième entrée (E2), la fréquence limite du passe-bas (TP) étant supérieure à la fréquence de signal maximale transmise par la voie des signaux de la première entrée (E1) au deuxième raccordement d'abonné (T2), lorsque la deuxième entrée (E2) fonctionne à vide, et inférieure à la fréquence de signal la plus basse, transmise au deuxième raccordement d'abonné (T1).

2. Prise d'antenne selon la revendication 1, caractérisée en ce qu'un premier passe-haut (HP1), dont la fréquence limite est supérieure à la fréquence limite du passe-bas (TP), est monté entre la deuxième sortie (A2) du distributeur double (ZV) et le premier raccordement d'abonné (T1).

3. Prise d'antenne selon la revendication 1 ou 2, caractérisée en ce qu'il est prévu un deuxième passe-haut (HP2) entre la deuxième entrée (E2) et le point de liaison (P) du passe-bas (TP) et du deuxième raccordement d'abonné (T2), dont la fréquence limite se situe entre celle du passe-bas (TP) et la fréquence la plus basse de la gamme de fréquences transmise, dans la voie des signaux qui va de la deuxième entrée (E2) au deuxième raccordement d'abonné (T2).

4. Prise d'antenne selon les revendications 2 et 3, caractérisée en ce que les fréquences limites des deux passe-haut (HP1, HP2) sont égales.

5. Prise d'antenne selon la revendication 2, caractérisée en ce qu'une bobine d'étranglement (DR) est montée en parallèle au premier passe-haut (HP1),

6. Prise d'antenne selon la revendication 3, caractérisée en ce qu'une bobine d'étranglement (DR) est montée en parallèle au deuxième passe-haut (HP2).

7. Prise d'antenne selon l'une des revendications 1 à 6, caractérisée en ce qu'il est prévu, en série avec le passe-bas (TB), un troisième passe-haut (HP3) dont la fréquence limite correspond à la fréquence la plus basse de la gamme de fréquence transmise dans la voie des signaux entre la première entrée (E1) et le deuxième raccordement d'abonné (T2).

8. Prise d'antenne selon l'une des revendications 1 à 7, caractérisée en ce qu'un élément d'amortissement (DG) est monté en série avec le passe-bas (TP).

9. Prise d'antenne selon la revendication 7 ou 8, caractérisée en ce que le passe-bas est constitué de deux passe-bas partiels (TP1, TP2) entre lesquels est ou sont monté(s) le troisième passe-haut (HP3) et/ou l'élément d'amortissement (DG).

10. Prise d'antenne selon la revendication 9, caractérisée en ce que les deux passe-bas partiels (TP1, TP2) et le troisième passe-haut (HP3) sont formés par deux demi-éléments passe-bas avec condensateur longitudinal monté entre eux.

11. Prise d'antenne selon l'une des revendications 1 à 10, caractérisée en ce que l'amortissement de distribution est choisi différemment aux deux sorties (A1, A2) du distributeur double (ZV) de manière que l'amortissement de raccordement aux deux premiers raccordements d'abonné (T1, T2) soit à peu près le même pour la réception par satellite par l'intermédiaire des deux entrées (E1, E2)
